# EUROPEAN PATENT APPLICATION

(11) **EP 4 614 014 A1**
(43) Date of publication of application: **10.09.2025**
(21) Application number: 23884683.6
(22) Date of filing: 25.10.2023
(51) Int. Cl.: F16C 11/04, G09F 9/30, H04M 1/02, G06F 1/16, F16C 11/10, H05K 5/02

(54) **HINGE MECHANISM AND ELECTRONIC DEVICE**

(30) Priority: 31.10.2022 CN 202211343868
(71) Applicant: Vivo Mobile Communication Co., Ltd., Dongguan, Guangdong 523863 (CN)
(72) Inventor: LIANG, Yuanbiao, Dongguan, Guangdong 523863 (CN); ZHAO, Hailong, Dongguan, Guangdong 523863 (CN)
(74) Representative: Lavoix
(86) International application number: PCT/CN2023/126447
(87) International publication number: WO 2024/093751

(57) **Abstract**

A hinge mechanism (A) and an electronic device are provided. The hinge mechanism (A) includes a hinge base (100) and a swing arm assembly (200). The swing arm assembly (200) includes a first rotating part (210), the first rotating part (210) is provided with a first arc-shaped fitting surface (211) and a second arc-shaped fitting surface (212) disposed opposite to each other, and the hinge base (100) includes a third arc-shaped fitting surface (110) and a fourth arc-shaped fitting surface (120), the third arc-shaped fitting surface (110) and the fourth arc-shaped fitting surface (120) are disposed opposite to each other and spaced apart to form guide space (130). The first rotating part (210) is disposed in the guide space (130), the first arc-shaped fitting surface (211) is in a sliding fit with the third arc-shaped fitting surface (110), the second arc-shaped fitting surface (212) is in a sliding fit with the fourth arc-shaped fitting surface (120), and the swing arm assembly (200) may be rotatably connected to the hinge base (100) through the sliding fit between the first arc-shaped fitting surface (211) and the third arc-shaped fitting surface (110), and the sliding fit between the second arc-shaped fitting surface (212) and the fourth arc-shaped fitting surface (120).

## Description

### CROSS-REFERENCE TO RELATED APPLICATIONS

The present invention claims priority to Chinese Patent Application No. 202211343868.2, filed with the China National Intellectual Property Administration on October 31, 2022 and entitled "HINGE MECHANISM AND ELECTRONIC DEVICE", which is incorporated herein by reference in its entirety.

### TECHNICAL FIELD

The present invention relates to the technical field of electronic devices, and in particular, to a hinge mechanism and an electronic device.

### BACKGROUND

With advancements in communication technology and rising user demands, display screens of electronic devices are becoming increasingly larger, positioning foldable screen electronic devices as a key trend for the future. Hinge mechanisms of the foldable screen electronic devices are a core component of the entire foldable screen electronic devices.

In related technologies, the hinge mechanisms used in the foldable screen electronic devices primarily include a swing arm, a hinge base, and a hinge cover. The swing arm includes a swing arm bearing, the hinge cover and the hinge base are assembled with screws to enclose a bearing groove, and the swing arm bearing is installed in the bearing groove and may slide relative to the bearing groove, so that the swing arm rotates relative to the hinge base. The bearing groove is enclosed by the hinge base and the hinge cover, and in a process in which the hinge base and the hinge cover enclose to form the bearing groove, a manufacturing tolerance and an assembly tolerance of the hinge base and the hinge cover are large. Consequently, it is prone to lead to a problem of jamming when the swing arm rotates relative to the hinge base after the swing arm bearing is assembled with the bearing groove.

### SUMMARY

This application discloses a hinge mechanism and an electronic device, to resolve a problem of jamming when a swing arm rotates relative to a hinge base after a swing arm bearing is assembled with a bearing groove because a manufacturing tolerance and an assembly tolerance of a hinge base and a hinge cover of a foldable screen electronic device in a related technology are large.

To solve the foregoing technical problem, this application is implemented as follows.

According to a first aspect, this application discloses a hinge mechanism, including a hinge base and a swing arm assembly, where the swing arm assembly includes a first rotating part, the first rotating part is provided with a first arc-shaped fitting surface and a second arc-shaped fitting surface disposed opposite to each other, the hinge base includes a third arc-shaped fitting surface and a fourth arc-shaped fitting surface, and the third arc-shaped fitting surface and the fourth arc-shaped fitting surface are disposed opposite to each other and spaced apart to form guide space. The first rotating part is disposed in the guide space, the first arc-shaped fitting surface is in a sliding fit with the third arc-shaped fitting surface, the second arc-shaped fitting surface is in a sliding fit with the fourth arc-shaped fitting surface, and the swing arm assembly may be rotatably connected to the hinge base through the sliding fit between the first arc-shaped fitting surface and the third arc-shaped fitting surface, and the sliding fit between the second arc-shaped fitting surface and the fourth arc-shaped fitting surface.

According to a second aspect, this application further discloses an electronic device, including a first housing, a second housing, and the hinge mechanism provided in the first aspect, where the first housing and the second housing are respectively disposed on two sides of the hinge base and are rotatably connected through the swing arm assembly and the hinge base.

The technical solutions used in this application can achieve the following technical effects.

According to the electronic device disclosed in the embodiments of this application, the third arc-shaped fitting surface and the fourth arc-shaped fitting surface are disposed on the hinge base, and the third arc-shaped fitting surface and the fourth arc-shaped fitting surface are disposed opposite to each other and spaced apart to form guide space, so that the swing arm assembly is disposed in the guide space. This causes the swing arm assembly to be separately in a sliding fit with the third arc-shaped fitting surface and the fourth arc-shaped fitting surface through the first arc-shaped fitting surface and the second arc-shaped fitting surface of the first rotating part, so that the swing arm assembly can be rotatably connected to the hinge base through the sliding fit between the first arc-shaped fitting surface and the third arc-shaped fitting surface, and the sliding fit between the second arc-shaped fitting surface and the fourth arc-shaped fitting surface. In this application, the third arc-shaped fitting surface and the fourth arc-shaped fitting surface are directly disposed on the hinge base to form the guide space. A manner in which the hinge base and the hinge cover are enclosed to form the shaft bearing groove in the related technology is no longer used. This avoids an error in a process of assembling the hinge base and the hinge cover, thereby alleviating a problem of jamming when the swing arm rotates relative to a support after the swing arm bearing is assembled with the bearing groove.

### BRIEF DESCRIPTION OF DRAWINGS

FIG. 1 is an overall schematic diagram of a hinge mechanism according to an embodiment of this application;
FIG. 2 is an exploded schematic diagram of a hinge mechanism according to an embodiment of this application;
FIG. 3 is a schematic diagram of a structure of a hinge base according to an embodiment of this application;
FIG. 4 is a schematic diagram of a structure of a swing arm assembly according to an embodiment of this application;
FIG. 5 is a cross-sectional view along A-A of FIG. 4;
FIG. 6 is a partial schematic diagram of a swing arm assembly fitting with a hinge base from a first perspective;
FIG. 7 is a partial schematic diagram of a swing arm assembly fitting with a hinge base from a second perspective;
FIG. 8 is a partial schematic diagram of a swing arm assembly fitting with a hinge base from a third perspective; and
FIG. 9 is an exploded schematic diagram of an electronic device.

### Reference numerals:

A: hinge mechanism;
100: hinge base; 110: third arc-shaped fitting surface; 120: fourth arc-shaped fitting surface; 130: guide space; 140: end cover; 150: reinforcing protrusion; 160: second arc-shaped depression; 161: arc-shaped step; 170: second arc-shaped protrusion;
200: swing arm assembly; 210: first rotating part; 211: first arc-shaped fitting surface; 212: second arc-shaped fitting surface; 220: stress buffer hole; 230: swing arm body; 231: first buffer part; 240: first arc-shaped protrusion; 250: first arc-shaped depression;
300: oil reservoir;
400: housing connecting frame; 410: second buffer part;
500: synchronous rotating mechanism;
610: first housing; 620: second housing; 630: flexible display screen.

### DESCRIPTION OF EMBODIMENTS

To make the objectives, technical solutions, and advantages of this application clearer, the following clearly and completely describes the technical solutions of this application with reference to specific embodiments and corresponding accompanying drawings of this application. Apparently, the described embodiments are merely some rather than all of the embodiments of this application. All other embodiments obtained by a person of ordinary skill in the art based on embodiments of this application without creative efforts shall fall within the protection scope of this application.

The technical solutions disclosed in embodiments of this application are described in detail below with reference to the accompanying drawings.

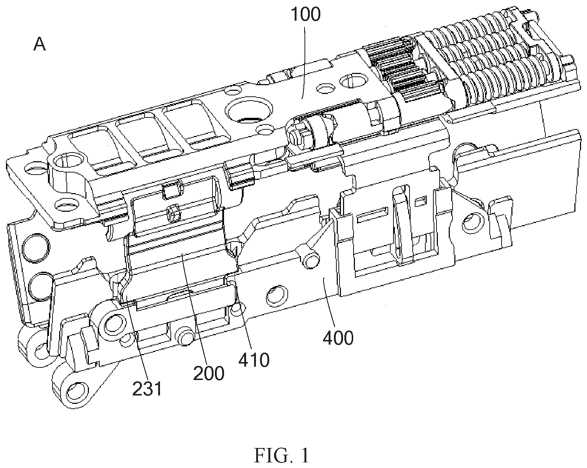

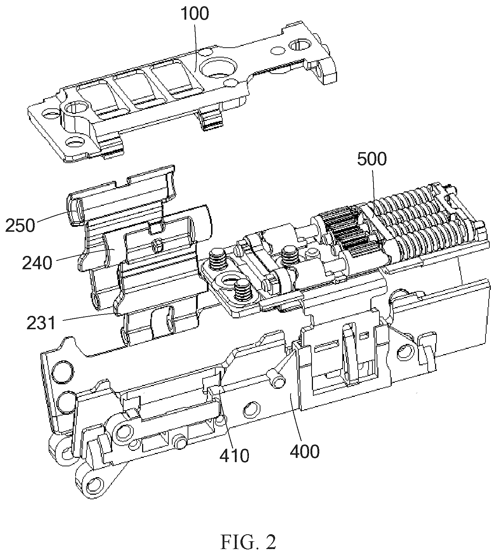

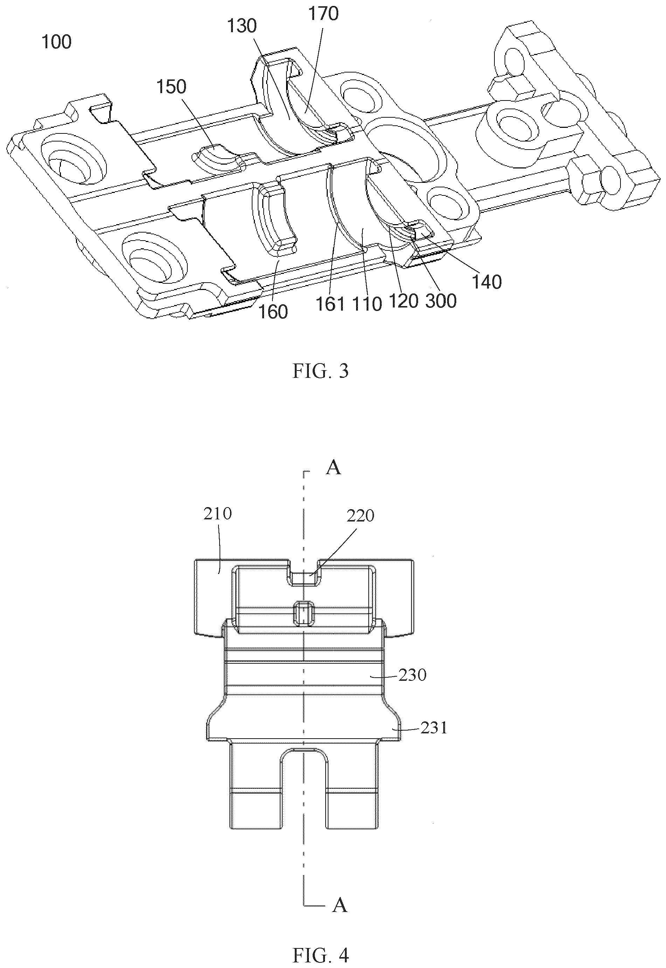

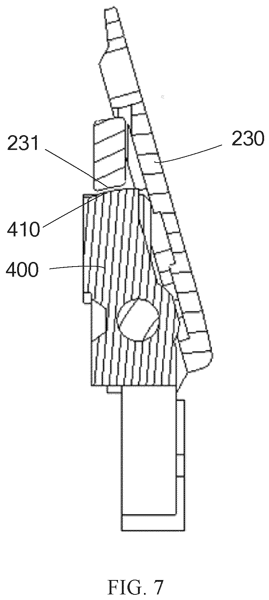

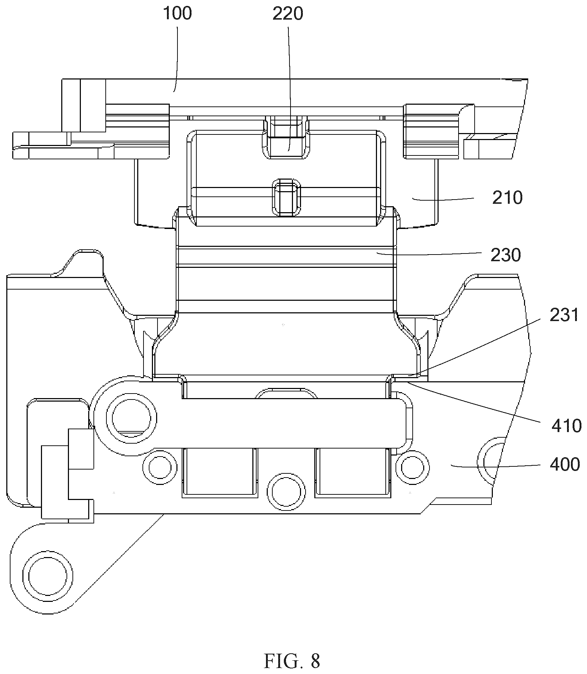

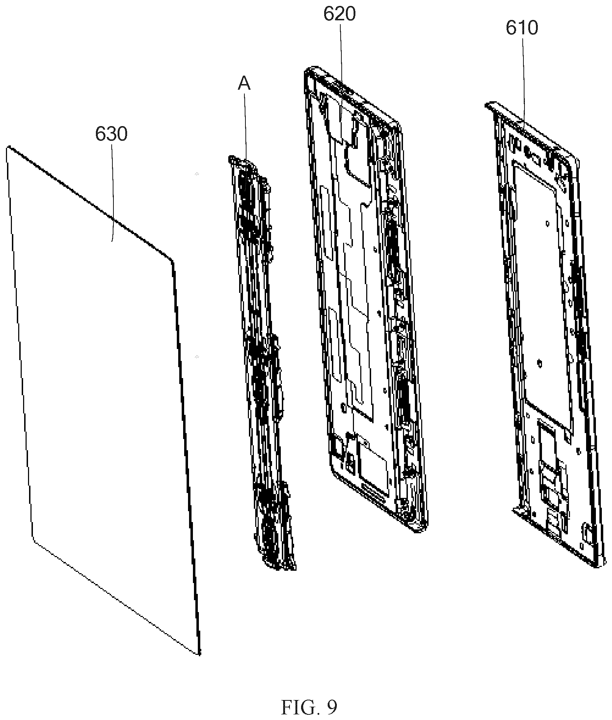

Refer to FIG. 1 to FIG. 9. An embodiment of this application discloses a hinge mechanism A, and the disclosed hinge mechanism A may be used in an electronic device such as a foldable screen mobile phone, a foldable screen tablet, a foldable screen game console, or the like.

The disclosed hinge mechanism A includes a hinge base 100 and a swing arm assembly 200. The swing arm assembly 200 includes a first rotating part 210, and the first rotating part 210 may be of an arc-shaped structure. The first rotating part 210 is provided with a first arc-shaped fitting surface 211 and a second arc-shaped fitting surface 212 disposed opposite to each other. The first arc-shaped fitting surface 211 and the second arc-shaped fitting surface 212 may be concentrically disposed.

The hinge base 100 includes a third arc-shaped fitting surface 110 and a fourth arc-shaped fitting surface 120, and the third arc-shaped fitting surface 110 and the fourth arc-shaped fitting surface 120 are disposed opposite to each other and spaced apart to form guide space 130. The guide space 130 may be arc-shaped guide space. The third arc-shaped fitting surface 110 and the fourth arc-shaped fitting surface 120 may be concentrically disposed.

The first rotating part 210 is disposed in the guide space 130, and the first arc-shaped fitting surface 211 is in a sliding fit with the third arc-shaped fitting surface 110, and the second arc-shaped fitting surface 212 is in a sliding fit with the fourth arc-shaped fitting surface 120. The swing arm assembly 200 may be rotatably connected to the hinge base 100 through the sliding fit between the first arc-shaped fitting surface 211 and the third arc-shaped fitting surface 110, and the sliding fit between the second arc-shaped fitting surface 212 and the fourth arc-shaped fitting surface 120.

According to the electronic device disclosed in the embodiments of this application, the third arc-shaped fitting surface 110 and the fourth arc-shaped fitting surface 120 are disposed on the hinge base 100, and the third arc-shaped fitting surface 110 and the fourth arc-shaped fitting surface 120 are disposed opposite to each other and spaced apart to form guide space 130, so that the first rotating part 210 is disposed in the guide space 130. This causes the swing arm assembly 200 to be separately in a sliding fit with the third arc-shaped fitting surface 110 and the fourth arc-shaped fitting surface 120 through the first arc-shaped fitting surface 211 and the second arc-shaped fitting surface 212 of the first rotating part 210, so that the swing arm assembly 200 can be rotatably connected to the hinge base 100 through the sliding fit between the first arc-shaped fitting surface 211 and the third arc-shaped fitting surface 110, and the sliding fit between the second arc-shaped fitting surface 212 and the fourth arc-shaped fitting surface 120. In this application, the third arc-shaped fitting surface 110 and the fourth arc-shaped fitting surface 120 are directly disposed on the hinge base 100 to form the guide space 130. A manner in which the hinge base and the hinge cover are enclosed to form the shaft bearing groove in the related technology is no longer used. This avoids an error in a process of assembling the hinge base and the hinge cover, thereby alleviating a problem of jamming when the swing arm rotates relative to a support after the swing arm bearing is assembled with the bearing groove.

A hinge base and a hinge cover of a foldable screen electronic device in the related technology usually use a screw fastening manner. Due to weak strength of the screw fastening manner, the bearing groove enclosed by the hinge base and the hinge cover is prone to deformation, thereby affecting smoothness of relative sliding between the swing arm bearing and the bearing groove, and leading to a risk of jamming. However, in this application, the third arc-shaped fitting surface 110 and the fourth arc-shaped fitting surface 120 are directly disposed on the hinge base 100, and the guide space 130 is enclosed. The hinge base 100 forms the guide space 130 in an integrated manner, and does not use a manner in which two parts are enclosed in the related technology. This avoids a problem in the related technology that the bearing groove enclosed by the hinge base and the hinge cover is prone to deformation, thereby affecting smoothness of relative sliding between the swing arm bearing and the bearing groove, and leading to a risk of jamming. In addition, screw fastening is not required in this application, so that space occupied by a screw can further be reduced. In this way, the hinge mechanism A is more compact, thereby facilitating a miniaturized design of the hinge mechanism A.

In an optional embodiment, at least one of the first rotating part 210 and the hinge base 100 is provided with an oil reservoir 300, and the oil reservoir 300 is configured to store lubricating medium, so as to deliver the lubricating medium to the sliding fit between the first arc-shaped fitting surface 211 and the third arc-shaped fitting surface 110, and the sliding fit between the second arc-shaped fitting surface 212 and the fourth arc-shaped fitting surface 120. The oil reservoir 300 may be provided on arc-shaped surfaces of the first arc-shaped fitting surface 211, the second arc-shaped fitting surface 212, the third arc-shaped fitting surface 110, and the fourth arc-shaped fitting surface 120. Of course, the oil reservoir 300 may alternatively be provided on other parts of the first rotating part 210 and the hinge base 100, provided that the oil reservoir 300 can deliver the lubricating medium to the sliding fit between the first arc-shaped fitting surface 211 and the third arc-shaped fitting surface 110, and the sliding fit between the second arc-shaped fitting surface 212 and the fourth arc-shaped fitting surface 120. The lubricating medium can be lubricating oil, lubricating grease, or the like.

In this embodiment of this application, at least one of the first rotating part 210 and the hinge base 100 is provided with the oil reservoir 300, so that when lubricating medium is disposed in the oil reservoir 300, the lubricating medium can be delivered to the sliding fit between the first arc-shaped fitting surface 211 and the third arc-shaped fitting surface 110, and the sliding fit between the second arc-shaped fitting surface 212 and the fourth arc-shaped fitting surface 120. In this way, the sliding fit between the first arc-shaped fitting surface 211 and the third arc-shaped fitting surface 110, and the sliding fit between the second arc-shaped fitting surface 212 and the fourth arc-shaped fitting surface 120 are smoother.

Optionally, the hinge base 100 may include an end cover 140, and the end cover 140 may be located at an end in a direction of a central axis of the third arc-shaped fitting surface 110, or the end cover 140 may be located at an end in a direction of a central axis of the fourth arc-shaped fitting surface 120. A first gap is formed between an end of the first arc-shaped fitting surface 211 and an end of the third arc-shaped fitting surface 110, a second gap is formed between an end of the second arc-shaped fitting surface 212 and an end of the fourth arc-shaped fitting surface 120, and the end cover 140 may seal the first gap and the second gap; and the oil reservoir 300 is provided on the end cover 140. End covers may be disposed on two ends in a direction of a central axis of the third arc-shaped fitting surface 110. Of course, alternatively, an end cover may be disposed on one end in a direction of a central axis of the third arc-shaped fitting surface 110.

In this embodiment of this application, the end cover 140 is disposed, so that the end cover 140 can seal the first gap formed between the end of the first arc-shaped fitting surface 211 and the end of the third arc-shaped fitting surface 110, and the second gap formed between the end of the second arc-shaped fitting surface 212 and the end of the fourth arc-shaped fitting surface 120. In this way, impurities such as dust can be prevented from entering a sliding fitting surface. In addition, the end cover 140 is provided with the oil reservoir 300, so that a problem of overflow of the lubricating medium due to rotation of the swing arm assembly 200 with respect to the hinge base 100 caused by the provision of the oil reservoir 300 on the arc-shaped surfaces of the first arc-shaped fitting surface 211, the second arc-shaped fitting surface 212, the third arc-shaped fitting surface 110, and the fourth arc-shaped fitting surface 120 can be avoided.

Optionally, the first rotating part 210 may be provided with a run-through stress buffer hole 220, and two openings of the stress buffer hole 220 are respectively located on the first arc-shaped fitting surface 211 and the second arc-shaped fitting surface 212. The run-through stress buffer hole 220 is disposed on the first rotating part 210, so that when the first rotating part 210 is impacted by an external force, the first rotating part 210 can convert kinetic energy into elastic potential energy through deformation of the stress buffer hole 220, so as to absorb impact energy. When the stress buffer hole 220 is restored from deformation, stress is released and the impact energy is removed, thereby preventing a fracture of the first rotating part 210 when the first rotating part 210 is impacted.

In an optional embodiment, an area in which the hinge base 100 fits with the first rotating part 210 is provided with a reinforcing protrusion 150, and in a process in which the first rotating part 210 rotates relative to the hinge base 100, the stress buffer hole 220 avoids the reinforcing protrusion 150.

Specifically, the reinforcing protrusion 150 is provided to compensate for reduced strength of the hinge base 100 due to the provision of the third arc-shaped fitting surface 110 and the fourth arc-shaped fitting surface 120 on the hinge base 100. In addition, in a process in which the swing arm assembly 200 rotates relative to the hinge base 100, the stress buffer hole 220 may avoid the reinforcing protrusion 150, thereby skillfully utilizing a structure of the stress buffer hole 220 to avoid a problem of the first rotating part 210 interfering with the reinforcing protrusion 150 when the swing arm assembly 200 rotates relative to the hinge base 100.

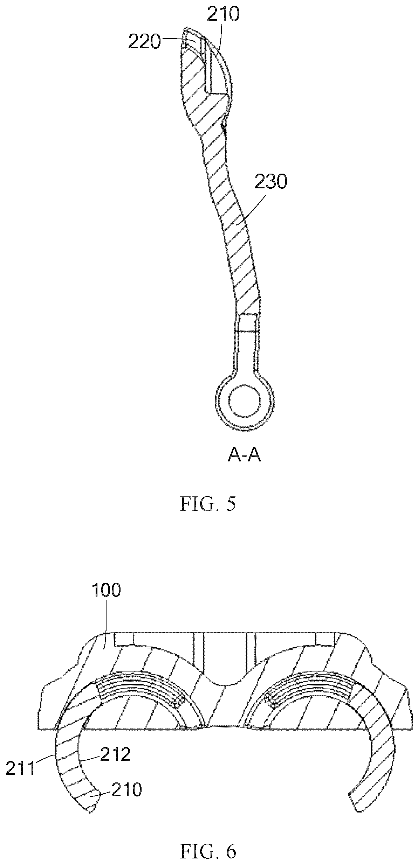

Optionally, the hinge mechanism A may further include a housing connecting frame 400, the swing arm assembly 200 may further include a swing arm body 230, the first rotating part 210 may be connected to a first end of the swing arm body 230, a second end of the swing arm body 230 may be connected to the housing connecting frame 400, a first buffer part 231 may be disposed on the swing arm body 230, a second buffer part 410 may be disposed on the housing connecting frame 400, and there is a buffer gap between the first buffer part 231 and the second buffer part 410. Specifically, as shown in FIG. 5, a mounting through hole may be disposed on the second end of the swing arm body 230, and a pin shaft may be connected to the housing connecting frame 400 through the mounting through hole, so that the second end of the swing arm body 230 is connected to the housing connecting frame 400.

Specifically, the housing connecting frame 400 may be configured to connect to a housing of the electronic device, and the housing of the electronic device may rotate through the hinge mechanism A, so that the electronic device switches between an expanded state and a folded state. The housing of the electronic device may provide a basis for mounting a component such as a screen of the electronic device.

In this embodiment of this application, the housing connecting frame 400 is disposed, and the swing arm assembly 200 is disposed to include the swing arm body 230, so that the first rotating part 210 can be connected to the first end of the swing arm body 230, and the second end of the swing arm body 230 can be connected to the housing connecting frame 400. In this way, the first buffer part 231 may be disposed on the swing arm body 230, the second buffer part 410 may be disposed on the housing connecting frame 400, and there is the buffer gap between the first buffer part 231 and the second buffer part 410. Therefore, when the hinge mechanism A or the electronic device is impacted, and an impact force is transmitted to the swing arm assembly 200, a deformation displacement is generated in the interior of the swing arm assembly 200, so that the first buffer part 231 and the second buffer part 410 are in a contact fit, and the first buffer part 231 can disperse the impact force of the swing arm assembly 200 through the second buffer part 410, thereby preventing the swing arm assembly 200 from fracturing due to the impact.

In an optional embodiment, two opposite ends of the first rotating part 210 may be respectively provided with a first arc-shaped protrusion 240 and a first arc-shaped depression 250, the first arc-shaped protrusion 240 and the first arc-shaped depression 250 may be provided opposite to each other, the first arc-shaped protrusion 240 may include the first arc-shaped fitting surface 211, and the first arc-shaped depression 250 may include the second arc-shaped fitting surface 212.

In this embodiment of this application, the two opposite ends of the first rotating part 210 are respectively provided with the first arc-shaped protrusion 240 and the first arc-shaped depression 250. The first arc-shaped protrusion 240 and the first arc-shaped depression 250 are provided opposite each other, so that the first arc-shaped fitting surface 211 is disposed in the first arc-shaped protrusion 240, and the second arc-shaped fitting surface 212 is disposed in the first arc-shaped depression 250. In this way, the first rotating part 210 can be supported through the first arc-shaped protrusion 240, so that a part between two first arc-shaped protrusions 240 of the first rotating part 210 can be prevented from being in contact with a third arc-shaped fitting surface 110. In addition, a contact surface on which the swing arm assembly 200 is in a rotational fit with the hinge base 100 is small, thereby reducing friction when the swing arm assembly 200 rotates relative to the hinge base 100.

Optionally, the hinge base 100 may include a second arc-shaped depression 160 and a second arc-shaped protrusion 170, each of two ends of the second arc-shaped depression 160 extending a direction of a central axis of the second arc-shaped depression 160 may be provided with an arc-shaped step 161, the arc-shaped step 161 may include the third arc-shaped fitting surface 110, the second arc-shaped protrusion 170 and the arc-shaped step 161 may be provided opposite to each other and spaced apart, and the second arc-shaped protrusion 170 may include the fourth arc-shaped fitting surface 120.

The hinge base 100 is provided with the second arc-shaped depression 160, so that each of the two ends of the second arc-shaped depression 160 extending the direction of the central axis of the second arc-shaped depression 160 is provided with the arc-shaped step 161. The arc-shaped step 161 includes the third arc-shaped fitting surface 110. The second arc-shaped protrusion 170 and the arc-shaped step 161 may be provided opposite to each other and spaced apart, and the second arc-shaped protrusion 170 may include the fourth arc-shaped fitting surface 120, so that the first rotating part 210 can extend into the second arc-shaped depression 160 and be in a rotational fit with the hinge base 100. This may reduce assembly space, thereby facilitating a miniaturization design of the hinge mechanism A. Moreover, the arc-shaped step 161 may further support the first arc-shaped protrusion 240, thereby further reducing the contact surface on which the swing arm assembly 200 is in a rotational fit with the hinge base 100.

In an optional embodiment, there are two swing arm assemblies 200, the two swing arm assemblies 200 may be disposed at two opposite ends of the hinge base 100, and the first rotating parts 210 of the two swing arm assemblies 200 are separately rotatably connected to the hinge base 100. The two swing arm assemblies 200 are disposed, so that a function of the hinge mechanism A can be more powerful.

Optionally, the hinge mechanism A may further include a synchronous rotating mechanism 500. The synchronous rotating mechanism 500 may be connected to the hinge base 100, and the synchronous rotating mechanism 500 may be connected to the housing connecting frame 400. When there are two swing arm assemblies 200, and the two swing arm assemblies 200 are both connected to housing connecting frames 400, the synchronous rotating mechanism 500 can be connected to the two housing connecting frames 400, so that the two housing connecting frames 400 can rotate synchronously relative to the hinge base 100.

This application further discloses an electronic device, and the disclosed electrical device includes the hinge mechanism A in the foregoing embodiment.

The electronic device may further include a first housing 610 and a second housing 620. The first housing 610 and the second housing 620 are respectively located on two sides of the hinge base 100. The first housing 610 and the second housing 620 may be rotatably connected through a swing arm and a hinge base, so that the electronic device switches between a folded state and an expanded state.

The electronic device may further include a flexible display screen 630. The flexible display screen 630 may be disposed on the first housing 610 and the second housing 620, and the flexible display screen 630 may rotate together with the first housing 610 and the second housing 620.

The foregoing embodiments of this application focus on describing differences between the embodiments, and different optimization features of the embodiments may be combined to form better embodiments provided that they are not contradictory. For brevity, details are not described herein again.

The embodiments of this application are described above with reference to the accompanying drawings, but this application is not limited to the foregoing specific implementations, and the foregoing specific implementations are only illustrative and not restrictive. Under the enlightenment of this application, a person of ordinary skill in the art can make many forms without departing from the purpose of this application and the protection scope of the claims, all of which fall within the protection of this application.

## Claims

1. A hinge mechanism, comprising a hinge base and a swing arm assembly, wherein
the swing arm assembly comprises a first rotating part, the first rotating part is provided with a first arc-shaped fitting surface and a second arc-shaped fitting surface disposed opposite to each other, the hinge base comprises a third arc-shaped fitting surface and a fourth arc-shaped fitting surface, and the third arc-shaped fitting surface and the fourth arc-shaped fitting surface are disposed opposite to each other and spaced apart to form guide space; and
the first rotating part is disposed in the guide space, the first arc-shaped fitting surface is in a sliding fit with the third arc-shaped fitting surface, the second arc-shaped fitting surface is in a sliding fit with the fourth arc-shaped fitting surface, and the swing arm assembly may be rotatably connected to the hinge base through the sliding fit between the first arc-shaped fitting surface and the third arc-shaped fitting surface, and the sliding fit between the second arc-shaped fitting surface and the fourth arc-shaped fitting surface.

2. The hinge mechanism according to claim 1, wherein at least one of the first rotating part and the hinge base is provided with an oil reservoir, and the oil reservoir is arranged to store lubricating medium, so as to deliver the lubricating medium to the sliding fit between the first arc-shaped fitting surface and the third arc-shaped fitting surface, or the sliding fit between the second arc-shaped fitting surface and the fourth arc-shaped fitting surface.

3. The hinge mechanism according to claim 2, wherein the hinge base comprises an end cover, the end cover is located at an end in a direction of a central axis of the third arc-shaped fitting surface, a first gap is formed between an end of the first arc-shaped fitting surface and an end of the third arc-shaped fitting surface, a second gap is formed between an end of the second arc-shaped fitting surface and an end of the fourth arc-shaped fitting surface, and the end cover seals the first gap and the second gap; and the oil reservoir is provided on the end cover.

4. The hinge mechanism according to claim 1, wherein the first rotating part is provided with a run-through stress buffer hole, and two openings of the stress buffer hole are respectively located on the first arc-shaped fitting surface and the second arc-shaped fitting surface.

5. The hinge mechanism according to claim 4, wherein an area in which the hinge base fits with the first rotating part is provided with a reinforcing protrusion, and in a process in which the first rotating part rotates relative to the hinge base, the stress buffer hole avoids the reinforcing protrusion.

6. The hinge mechanism according to claim 1, wherein the hinge mechanism further comprises a housing connecting frame, the swing arm assembly further comprises a swing arm body, the first rotating part is connected to a first end of the swing arm body, a second end of the swing arm body is connected to the housing connecting frame, a first buffer part is disposed on the swing arm body, a second buffer part is disposed on the housing connecting frame, and there is a buffer gap between the first buffer part and the second buffer part.

7. The hinge mechanism according to claim 1, wherein two opposite ends of the first rotating part are respectively provided with a first arc-shaped protrusion and a first arc-shaped depression, the first arc-shaped protrusion and the first arc-shaped depression are provided opposite to each other, the first arc-shaped protrusion comprises the first arc-shaped fitting surface, and the first arc-shaped depression comprises the second arc-shaped fitting surface.

8. The hinge mechanism according to claim 7, wherein the hinge base comprises a second arc-shaped depression and a second arc-shaped protrusion, each of two ends of the second arc-shaped depression extending a direction of a central axis of the second arc-shaped depression is provided with an arc-shaped step, the arc-shaped step comprises the third arc-shaped fitting surface, the second arc-shaped protrusion and the arc-shaped step are provided opposite to each other and spaced apart, and the second arc-shaped protrusion comprises the fourth arc-shaped fitting surface.

9. The hinge mechanism according to claim 1, wherein there are two swing arm assemblies, the two swing arm assemblies are disposed at two opposite ends of the hinge base, and the first rotating parts of the two swing arm assemblies are separately rotatably connected to the hinge base.

10. An electronic device, comprising a first housing, a second housing, and the hinge mechanism according to any one of claims 1 to 9, wherein
the first housing and the second housing are respectively disposed on two sides of the hinge base and are rotatably connected through the swing arm assembly and the hinge base.
